# EUROPÄISCHE PATENTSCHRIFT

(11) **EP 0 586 716 B1**
(45) Veröffentlichungstag und Bekanntmachung des Hinweises auf die Patenterteilung: **22.10.1997**
(21) Anmeldenummer: 92113628.9
(22) Anmeldetag: 10.08.1992
(51) Int. Cl.: H01L 29/772, H01L 29/10

(54) **Leistungs-MOSFET mit verbesserter Avalanche-Festigkeit**
Power MOSFET with improved avalanche stability
MOSFET de puissance à stabilité d'avalanche améliorée

(43) Veröffentlichungstag der Anmeldung: 16.03.1994
(73) Patentinhaber: SIEMENS AKTIENGESELLSCHAFT, 80333 München (DE)
(72) Erfinder: Hertrich, Helmut, Dipl.-Phys., W-8049 Fahrenzhausen (DE)

(56) Entgegenhaltungen:
- EP-A- 0 323 843
- EP-A- 0 466 508
- GB-A- 2 033 658
- GB-A- 2 240 427
- PATENT ABSTRACTS OF JAPAN, vol. 14, no. 263 (E-938) 7. Juni 1990; & JP-A-20 82 534

## Beschreibung

Die Erfindung bezieht sich auf einen Leistungs-MOSFET mit einer Vielzahl von auf einem Halbleiterkörper angeordneten parallelgeschalteten Zellen, die jeweils aus einer Gatezone und einer darin planar eingebetteten Sourcezone bestehen, mit einer Metallschicht, die die Gatezonen durch in den Sourcezonen angebrachte Kontaktlöcher kontaktiert, sowie mit parallelgeschalteten Gateelektroden.

Ein solcher Leistungs-MOSFET ist z. B. in der EP-A 293 846 beschrieben worden. Hier wird das Ziel verfolgt, den meist am Rand des Zellenfeldes fließenden Avalanchestrom zu erhöhen, ohne daß der parasitäre Bipolartransistor eingeschaltet und der Transistor zerstört wird. In der genannten Anmeldung wurde vorgeschlagen, die dem Rand benachbarten Zellen des Zellenfeldes ohne Sourcezone oder mit verkleinerter Sourcezone herzustellen. Da Leistungs-MOSFET im allgemeinen in selbstjustierender Technik gefertigt werden, indem die Gateelektroden die Implantationsmaske sowohl für die Gatezonen als auch für die Sourcezonen bilden, erfordert das beschriebene Halbleiterbauelement eine zusätzliche Maske.

Aus der EP 323 843 und der GB 20 33 658 sind Leistungs-MOS-FETS mit den Merkmalen des Oberbegriffs des Anspruchs 1 bekannt, bei denen die Gateelektroden durch spezielle Justierschritte auf die zuvor hergestellten Sourcezonen ausgerichtet werden müssen. Dies erfordert jedoch zusätzliche Maskierschritte.

Es ist Ziel der vorliegenden Erfindung, die Avalanche-Festigkeit bei vereinfachtem Herstellungsverfahren weiter zu erhöhen. Daneben soll auch die Kommutierungs-Festigkeit erhöht werden.

Dieses Ziel wird erreicht durch die Merkmale:
a) die Metallschicht (6) kontaktiert die Gatezonen (9) durch in den Sourcezonen (10) angebrachte Kontaktlöcher (3),
b) die ringförmige Zone (4) hat einen ringförmigen Graben (5) mit der gleichen Tiefe wie die Kontaktlöcher (3),
c) die Metallschicht kontaktiert die ringförmige Zone (4) im ringförmigen Graben (5)
d) zwischen dem ringförmigen Graben und dem Rand (13) des Halbleiterkörpers ist der Halbleiterkörper mit einer Isolierschicht (12) bedeckt,
e) auf der Isolierschicht ist eine leitende Schicht (8) angeordnet, die gleichzeitig mit den Gateelektroden aufgebracht ist,
f) das zwischen Graben (5) und dem Rand (13) des Halbleiterkörpers liegende Teil der ringförmigen Zone (4) ist frei von dem Leitungstyp der Sourcezonen (10, 20) entsprechenden Zonen.

Weiterbildungen der Erfindung sind Gegenstand der Unteransprüche.

Die Erfindung wird anhand eines Ausführungsbeispiels in Verbindung mit den Figuren 1 bis 3 näher erläutert.

Es zeigen
- Figur 1: einen Schnitt durch einen erfindungsgemäßen Leistungs-FET
- Figur 2: eine vereinfachte Aufsicht auf die Anordnung nach Figur 1 und
- Figur 3: eine vergrößerte Darstellung eines durch die gestrichelte Linie 14 umrandeten Ausschnittes der Figur 2.

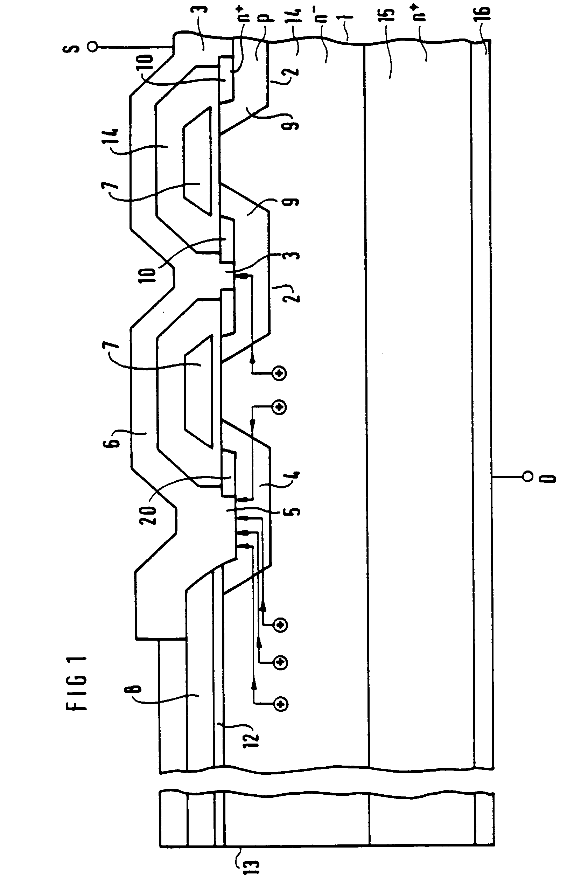

Der Leistungs-FET nach Figur 1 hat einen Halbleiterkörper 1 mit einer schwach n-dotierten Zone 14, die auf einem stark n-dotierten Substrat 15 aufgebracht ist. In die schwach n-dotierte Schicht 14 sind Transistorzellen 2 ein- gebettet. Diese haben p-dotierte Gatezonen 9, in die stark n-dotierte Sourcezonen 10 eingebettet sind. Zwischen den Zellen 2 und dem Rand 13 liegt eine ringförmige Zone 4, die sämtliche Zellen 2 des Leistungs-FET umgibt. Die ringförmige Zone 4 hat die gleiche Dotierung und die gleiche Tiefe wie die Gatezonen 9. Die Gatezonen werden von einer Metallschicht 6 durch in den Sourcezonen 10 vorgesehene Kontaktlöcher 3 kontaktiert. Die Metallschicht 6 kontaktiert außerdem die Sourcezonen 10. Sie ist mit einem Sourceanschluß S versehen. Das Substrat 15 ist über eine Elektrode 16 mit einem Drainanschluß D verbunden.

Die ringförmige Zone 4 hat einen ringförmigen Graben 5, der die gleiche Tiefe wie die Kontaktlöcher 3 hat. Sie wird durch die Metallschicht 6 im Graben 5 kontaktiert.

Über den Zellen 2 sind in bekannter Weise Gateelektroden 7 angeordnet, die als Maske zur Implantation der Gatezonen 9 und der Sourcezonen 10 verwendet werden. Der Halbleiterkörper ist zwischen der ringförmigen Zone 4 und dem Rand 13 mit einer Isolierschicht 12 bedeckt, auf der eine leitende Schicht 8 angeordnet ist. Die leitende Schicht 8 besteht vorzugsweise aus dem gleichen Material wie die Gateelektroden 7, z. B. aus dotiertem Polysilizium. Sie wird gleichzeitig mit den Elektroden 7 hergestellt, hat eine abgeschrägte Flanke und dient zusammen mit der dem Rand 13 am nächsten liegenden Gateelektrode 7 als Maske zur Herstellung der ringförmigen Zone 4. Zusammen mit den Source-Sourcezonen 10 in den Zellen 2 wird zunächst auch in der Zone 4 eine Sourcezone 20 erzeugt.

Der ringförmige Graben 5 in der ringförmigen Zone 4 wird nun derart angeordnet, daß die Zone 20 in dem zwischen dem dem Rand 13 zugewandten Volumen der ringförmigen Zone 4 entfernt wird.

Wird an den Transistor über den Sourceanschluß S und den Drainanschluß D eine Sperrspannung angelegt, so baut sich an den pn-Übergängen zwischen den Zonen 9 und 14 eine Raumladungszone auf. Wird die Spannung gesteigert, so kommt es bei Erreichen der kritischen Feldstärke Eₖᵣᵢₜ zum Avalanche-Durchbruch. Der Avanlanche-Durchbruch tritt, wie die Praxis gezeigt hat, insbesondere in der Nähe des Randes des Leistungs-FET auf. Hierbei werden Ladungsträgerpaare erzeugt, von denen die negativen Ladungsträger zur Drainelektrode D und die positiven Ladungsträger zur Sourceelektrode S abfließen. Die am Rand des Halbleiterkörpers erzeugten Ladungsträgerpaare fließen in die ringförmige Zone 4 und von dort in die Metallschicht 6 ab. Der unter den Sourcezonen 10 und der Sourcezone 20 restliche lateral verlaufende Avalanche-Strom wird dadurch so gering, daß eine Emission von Ladungsträgern aus den Sourcezonen 10, 20 unterbleibt, d.h. daß der parasitäre polartransitor nicht einschalten kann.

Der beschriebene Leistungs-FET läßt sich sehr einfach ohne zusätzliche Maske herstellen. Dadurch, daß der ringförmige Graben 5 die gleiche Tiefe wie die Kontaktlöcher 3 hat, läßt er sich gleichzeitig mit ihnen ätzen. Die für die Herstellung der Kontaktlöcher 3 ohnehin benötigte Ätzmaske wird dazu so erweitert, daß die in die ringförmige Zone 4 implantierte Sourcezone 20 zumindest teilweise weggeätzt wird. Der dabei entstehende ringförmige Graben wird so gelegt, daß die Sourcezone 20 auf der dem Rand 13 zugewandten Seite vollkommen weggeätzt ist. Auf der vom Rand 13 abgewandten Seite des ringförmigen Grabens 5 kann ein Teil der Sourcezone 20 stehen bleiben.

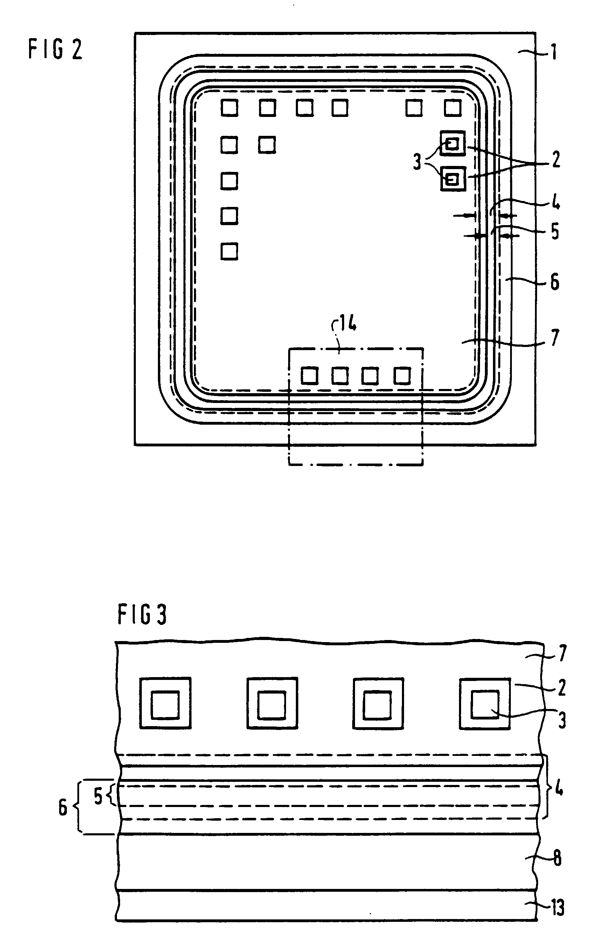

In Figur 2 ist die Aufsicht auf die Anordnung nach Figur 1 in vereinfachter Weise dargestellt. Gleiche Teile wie in Figur 1 sind mit gleichen Bezugszeichen versehen. Die Metallschicht 6 wurde über dem Zellenfeld weggelassen, so daß hier die Gateelektroden 7 für die einzelnen Zellen 2 sichtbar werden. Die Gateelektroden werden durch eine durchgehende Schicht Polysilizium gebildet. In Figur 1 ist lediglich der den ringförmigen Graben 5 kontaktierende Teil der Metallisierung 6 dargestellt.

In Figur 3 sind Einzelheiten der Figur 2 dargestellt. Hier ist deutlich zu erkennen, daß die Schicht der Gateelektroden 7 die ringförmige Zone 4 überdeckt. Innerhalb der ringförmigen Zone 4 ist der ringförmige Graben 5 angeordangeordnet, der vollständig von der Metallschicht 6 überüberdeckt ist. Die Metallschicht 6 kontaktiert die leitende Schicht 8. Zwischen der leitenden Schicht 8 und den Gateelektroden 7 besteht keine elektrisch leitende Verbindung. Die leitende Schicht 8 liegt vielmehr über die Metallschicht 6 auf Sourcepotential und wirkt damit als Feldplatte.

## Patentansprüche

1. Leistungs-MOSFET mit einer Vielzahl von auf einem Halbleiterkörper angeordneten, parallelgeschalteten Zellen, die jeweils aus einer Gatezone und einer darin planar eingebetteten Sourcezone bestehen, mit einer ringförmigen Zone vom Leitungstyp der Gatezonen, die die Zellen umgibt und die die gleiche Tiefe und Dotierung wie die Gatezonen hat, mit einer Metallschicht, die die Gatezonen, die Sourcezonen, und die ringförmige Zone kontaktiert, sowie mit einander parallelgeschalteten Gateelektroden,
**gekennzeichnet durch** die Merkmale:
a) die Metallschicht (6) kontaktiert die Gatezonen (9) durch in den Sourcezonen (10) angebrachte Kontaktlöcher (3),
b) die ringförmige Zone (4) hat einen ringförmigen Graben (5) mit der gleichen Tiefe wie die Kontaktlöcher (3),
c) die Metallschicht kontaktiert die ringförmige Zone (4) im ringförmigen Graben (5) d) zwischen dem ringförmigen Graben und dem Rand (13) des Halbleiterkörpers ist der Halbleiterkörper mit einer Isolierschicht (12) bedeckt,
e) auf der Isolierschicht ist eine leitende Schicht (8) angeordnet, die gleichzeitig mit den Gateelektroden aufgebracht ist,
f) das zwischen Graben (5) und dem Rand (13) des Halbleiterkörpers liegende Teil der ringförmigen Zone (4) ist frei von dem Leitungstyp der Sourcezonen (10, 20) entsprechenden Zonen.

2. Leistungs-MOSFET nach Anspruch 1,
**dadurch gekennzeichnet,** daß die Metallschicht über denjenigen Rand der ringförmigen Zone hinausragt, der auf der Seite des Randes (13) des Halbleiterkörpers liegt.

3. Leistungs-MOSFET nach Anspruch 2,
**dadurch gekennzeichnet,** daß die Metallschicht (6) die leitende Schicht (8) kontaktiert.

## Claims

1. Power MOSFET, having a multiplicity of cells which are arranged on a semiconductor body, are connected in parallel and each comprise a gate zone and a source zone embedded therein in a planar manner, having an annular zone which is of the conduction type of the gate zones, surrounds the cells and has the same depth and doping as the gate zones, having a metal layer which makes contact with the gate zones, the source zones and the annular zone, and also having gate electrodes which are connected in parallel with one another, characterized by the features:
a) the metal layer (6) makes contact with the gate zones (9) through contact holes (3) made in the source zones (10),
b) the annular zone (4) has an annular trench (5) having the same depth as the contact holes (3),
c) the metal layer makes contact with the annular zone (4) in the annular trench (5)
d) the semiconductor body is covered with an insulating layer (12) between the annular trench and the edge (13) of the semiconductor body,
e) a conductive layer (8) which is applied at the same time as the gate electrodes is arranged on the insulating layer,
f) that part of the annular zone (4) which lies between the trench (5) and the edge (13) of the semiconductor body is free of zones corresponding to the conduction type of the source zones (10, 20).

2. Power MOSFET according to Claim 1, characterized in that the metal layer projects beyond that edge of the annular zone which is situated on the side of the edge (13) of the semiconductor body.

3. Power MOSFET according to Claim 2, characterized in that the metal layer (6) makes contact with the conductive layer (8).

## Revendications

1. MOSFET de puissance avec une multitude de cellules disposées sur un corps semi conducteur et commutées en parallèle qui, chaque fois, se compose d'une zone de porte et d'une zone de source incorporée dans celle-ci de manière plane, avec une zone annulaire du type de conductivité des zones de porte qui entoure les cellules et qui a la même profondeur et le même dopage que les zones de porte avec une couche métallique qui contacte les zones de porte, les zones de source et la zone annulaire, ainsi qu'avec des électrodes de porte connectées en parallèle entre elles,
caractérisé en ce que :
a) la couche métallique (6) contacte les zones de porte (9) à travers des trous de contact (3) disposés dans les zones de source (10),
b) la zone annulaire (4) possède une rainure annulaire (5) de même profondeur que les trous de contact (3)
c) la couche métallique contacte la zone annulaire (4) dans la rainure annulaire (5)
d) entre la rainure annulaire et le bord (13) du corps semi conducteur, le corps semi conducteur est recouvert d'une couche isolante (12)
e) sur la couche isolante est disposée une couche conductrice (8) qui est mise en place simultanément avec les électrodes de porte
f) la partie de la zone annulaire (4) qui se situe entre la rainure (5) et le bord (13) du corps semi conducteur est exempte de zones correspondant au type de conductivité des zones de source (10, 20).

2. MOSFET de puissance selon la revendication 1,
caractérisé en ce que la couche métallique dépasse le bord correspondant de la zone annulaire qui se situe sur le côté du bord (13) du corps semi conducteur.

3. MOSFET de puissance selon la revendication 2,
caractérisé en ce que la couche métallique (6) contacte la couche conductrice (8).
